# FASCICULE DE BREVET EUROPEEN

(11) **EP 0 846 941 B1**
(45) Date de publication et mention de la délivrance du brevet: **05.03.2003**
(21) Numéro de dépôt: 97402948.0
(22) Date de dépôt: 05.12.1997
(51) Int. Cl.: G01L 9/00

(54) **Procédé d'introduction d'une phase gazeuse dans une cavité fermée**
Verfahren zum Einbringen einer Gasphase in einen geschlossenen Hohlraum
Procedure for introducing a gaseous phase into a closed cavity

(30) Priorité: 09.12.1996 FR 9615091
(43) Date de publication de la demande: 10.06.1998
(73) Titulaire: COMMISSARIAT A L'ENERGIE ATOMIQUE, 75015 Paris (FR)
(72) Inventeur: Bruel, Michel, 38113 Veurey (FR)
(74) Mandataire: Dubois-Chabert, Guy

(56) Documents cités:
- FR-A- 2 681 472

## Description

La présente invention concerne un procédé d'introduction d'une phase gazeuse dans une cavité fermée. Cette cavité peut être constituée dans tout type de matériau solide : conducteur, semiconducteur ou diélectrique.

L'introduction d'une phase gazeuse dans une cavité fermée peut présenter de l'intérêt dans certains domaines de la technique. Dans le domaine de la microélectronique notamment, l'introduction d'une phase gazeuse permettrait de réaliser des micro-coussinets pressurisés utilisables comme capteurs de pression ou pour former des éléments à contact souple.

L'obtention de tels micro-coussinets pressurisés dans des dispositifs relevant de la microélectronique semble particulièrement difficile à obtenir par des procédés classiques. En effet, la plupart des procédés microélectroniques se déroulent dans des machines à basse pression ou à pression atmosphérique. Dans ces conditions, si on peut introduire une phase gazeuse à une pression déterminée dans une micro-cavité réalisée dans une structure en établissant une communication physique avec un milieu contenant le gaz correspondant à une pression désirée, il est difficile, voire impossible, de fermer la micro-cavité en gardant la phase gazeuse à la pression voulue.

L'inventeur de la présente invention a découvert qu'il est possible d'introduire une phase gazeuse dans une cavité fermée présente dans une structure sans avoir besoin de réaliser une communication physique entre cette cavité et l'extérieur. Il a découvert qu'il est possible d'introduire cette phase gazeuse par implantation d'ions aptes à générer le gaz en question dans la cavité, au travers d'une paroi fermant cette cavité.

L'invention a donc pour objet un procédé d'introduction d'une phase gazeuse dans au moins une cavité fermée et présente au sein d'une structure, caractérisé en ce qu'il consiste à effectuer une implantation ionique pour introduire des ions aptes à générer la phase gazeuse désirée dans la cavité, ladite implantation étant effectuée avec une énergie suffisante pour que les ions puissent atteindre la cavité et selon une dose suffisante pour obtenir une pression déterminée dans la cavité.

On entend par "ions aptes à générer la phase gazeuse" le fait que ces ions introduits dans la cavité peuvent, après interaction entre eux et/ou avec les atomes environnants, produire des molécules de gaz formées par une combinaison de ces ions neutralisés entre eux et/ou de ces ions neutralisés avec ces atomes.

La phase gazeuse peut résulter de l'implantation d'ions d'éléments différents. Ces ions sont avantageusement des ions d'hydrogène ou de gaz rares, en particulier de l'hélium.

Avantageusement, l'énergie d'implantation est telle qu'elle permet d'obtenir une concentration maximum théorique des ions à l'intérieur de la cavité.

L'implantation ionique peut être effectuée selon une dose permettant de conférer à la phase gazeuse constituée dans ladite cavité une pression suffisante pour déformer une paroi de la cavité. On peut ainsi conférer à la paroi déformée la forme d'un bossage ou d'un coussinet. Si la face externe de cette paroi est rendue conductrice, la structure peut ainsi présenter un contact électrique souple à un élément extérieur.

Selon un autre aspect de l'invention, il peut être prévu la formation d'électrodes positionnées de façon à former au moins un condensateur où ladite phase gazeuse intervient comme diélectrique.

Selon ce dernier aspect de l'invention, le procédé peut être utilisé pour obtenir un capteur de pression par mesure de la capacité du condensateur. Il peut aussi être utilisé pour obtenir une matrice de capteurs de pression par mesure des capacités correspondant aux condensateurs formés à partir d'une matrice de cavités implantées.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est un diagramme illustrant le profil de concentration d'ions implantés dans un matériau ;
- les figures 2A, 2B et 2C sont des vues en coupe illustrant la réalisation d'une cavité dans une structure semiconductrice ;
- la figure 3 est une vue de dessus d'une matrice de capteurs de pression réalisée en appliquant le procédé de l'invention ;
- la figure 4 est une vue en coupe transversale d'une structure présentant un contact électrique souple, obtenue en appliquant le procédé selon l'invention.

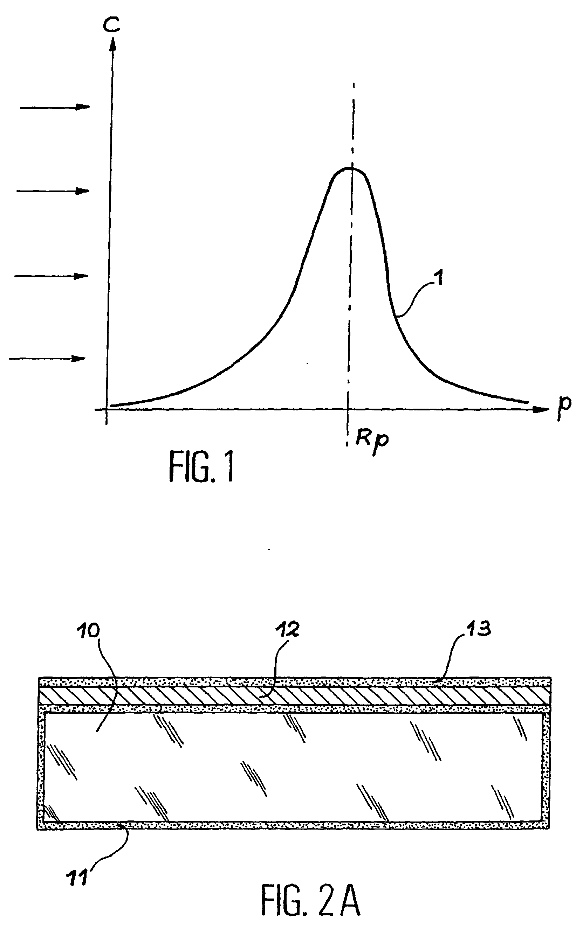

Lorsque l'on bombarde une plaquette d'un matériau solide par des ions, ceux-ci pénètrent plus ou moins profondément dans la plaquette en fonction de l'énergie qui leur est donnée et en fonction de la nature du matériau. En considérant que la plaquette est réalisée en un matériau homogène, qu'elle possède une face plane et que le bombardement ionique est réalisé par un faisceau d'ions possédant une énergie déterminée, les ions implantés dans la plaquette vont se répartir autour d'une profondeur moyenne avec une concentration maximum autour de cette profondeur moyenne. La figure 1 montre un exemple d'un profil de concentration ionique correspondant à l'implantation d'ions H⁺ (protons) dans une plaquette de silicium monocristallin. Pour plus de détail on pourra se reporter au document FR-A-2 681 472 décrivant un "Procédé de fabrication de films minces de matériau semiconducteur".

Sur la figure 1, l'axe des ordonnées correspond à la face plane de la plaquette par laquelle pénètre un faisceau d'ions d'énergie déterminée et symbolisé par des flèches. L'axe des abscisses, parallèle à la direction du faisceau d'ions, représente la profondeur p de la plaquette. La courbe 1 représente le profil de concentration C des ions implantés, l'implantation ayant été réalisée à une température déterminée, par exemple à température ambiante. La courbe 1 montre que la concentration d'ions implantés est maximale pour la profondeur Rp. Il est donc possible de concentrer une quantité relativement importante d'ions à une profondeur déterminée à l'intérieur d'un élément solide..

En ajustant les paramètres d'implantation de manière appropriée, il est alors possible d'obtenir un maximum de concentration d'ions, de la phase gazeuse que l'on désire introduire, qui pénètrent dans la cavité. Par masquage, il est également possible d'introduire la phase gazeuse uniquement dans la cavité et d'éviter toute implantation ionique dans le matériau environnant la cavité.

Une cavité peut exister de façon naturelle dans le matériau constituant une structure mais, de manière plus courante, on la réalise par usinage. L'invention s'applique à ces deux éventualités.

A titre d'exemple, on va décrire l'introduction d'une phase gazeuse dans une cavité réalisée dans une structure semiconductrice.

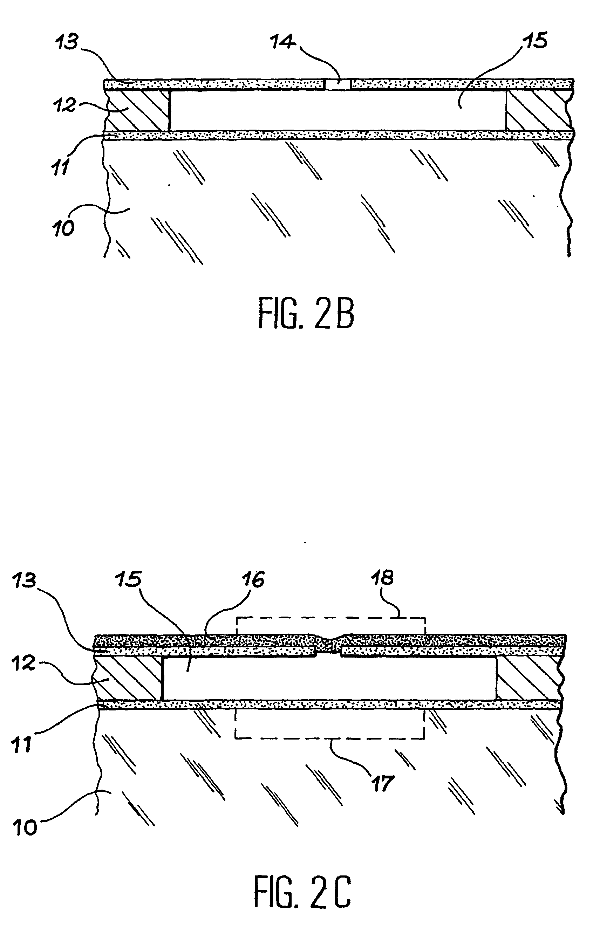

Les figures 2A, 2B et 2C sont des vues en coupe transversale d'une structure semiconductrice élaborée à partir d'un substrat 10 de silicium monocristallin dopé n, par exemple. Par oxydation thermique, on forme sur le substrat 10 une couche d'oxyde 11 de 500 nm d'épaisseur. Sur une face de la structure obtenue, on dépose une couche 12 de silicium polycristallin de 500 nm d'épaisseur. A la surface de la couche 12 de silicium polycristallin on forme, par oxydation thermique du silicium polycristallin, une couche 13 d'oxyde de 500 nm d'épaisseur. L'oxydation consommant environ 250 nm du silicium polycristallin de la couche 12, l'épaisseur restante de cette couche est de 250 nm.

Par une technique classique de lithogravure, on crée une ouverture 14 dans la couche supérieure d'oxyde 13. Cette ouverture 14 est par exemple un trou de 1 µm de diamètre. A partir de l'ouverture 14, on peut attaquer la couche de silicium polycristallin 12 grâce à un bain d'hydroxyde de tétraméthylammonium (TMAH). On peut ainsi obtenir une cavité 15 de 200 µm de diamètre, centrée sur l'ouverture 14 (voir la figure 2B).

Après une étape de séchage, on dépose sur la couche d'oxyde 13 une nouvelle couche d'oxyde 16 permettant de fermer l'ouverture 14. On obtient ainsi une cavité 15 fermée dans la structure semiconductrice (voir la figure 2C).

Dans cet exemple de réalisation, la cavité 15 a la forme d'un disque de 200 µm de diamètre. L'épaisseur de l'ensemble constitué par les couches 13 et 16 peut être de l'ordre de 1 µm et joue donc le rôle d'une membrane fermant la cavité 15. Cette membrane sera donc sensible aux différences de pression existant entre l'intérieur et l'extérieur de la cavité. L'introduction d'une phase gazeuse dans la cavité permettra de lui conférer une pression déterminée.

L'implantation ionique peut être effectuée avec des ions d'hydrogène ou de gaz rares, de préférence de l'hélium. La phase gazeuse peut éventuellement être constituée d'un mélange de gaz. L'implantation est réalisée de façon que le maximum de concentration ionique se situe à l'intérieur de la cavité et selon une dose telle que la phase gazeuse atteigne la pression souhaitée.

De préférence, l'énergie d'implantation est choisie telle que, quand les ions ont traversé la paroi fermant la cavité, ils débouchent dans cette cavité avec une énergie moyenne très faible, par exemple inférieure à 1 keV. Une partie des ions est ralentie par interaction avec les atomes et molécules existant dans la cavité. D'autres ions vont rebondir sur la paroi de fond de la cavité. D'autres encore vont s'y implanter en surface. La concentration en surface du fond de la cavité atteint très rapidement la saturation et par conséquent un équilibre est atteint et, pour chaque ion implanté, un ion est désorbé. Le résultat est que, dans le cas de l'implantation d'ions hydrogène, ces ions s'accumulent dans la cavité et se recombinent pour former du gaz H₂, générant ainsi une pression gazeuse. A titre d'exemple, si l'épaisseur d'oxyde au-dessus de la cavité est de 500 nm, on choisira une énergie d'implantation d'environ 60 keV.

L'application de la loi des gaz parfaits donne les résultats suivants. Pour une cavité de 1 µm d'épaisseur moyenne, il faut 6.10¹⁵ ions H⁺/cm² pour générer une pression d'hydrogène de 1 bar. Par conséquent pour la même cavité, il faudra 10 fois plus d'ions H⁺ pour générer une pression de 10 bar.

La cavité fermée représentée à la figure 2C, pressurisée à une pression déterminée, peut servir de capteur capacitif de pression, la phase gazeuse contenue à l'intérieur de la cavité 15 intervenant comme diélectrique. Dans ce cas, des électrodes de condensateur peuvent être constituées d'une part par le dopage p⁺ initial d'une région du substrat 10, pour obtenir le caisson 17 représenté en trait interrompu, et d'autre part par le dépôt d'une électrode métallique 18 (par exemple en aluminium), représentée également en trait interrompu, sur la couche d'oxyde 16.

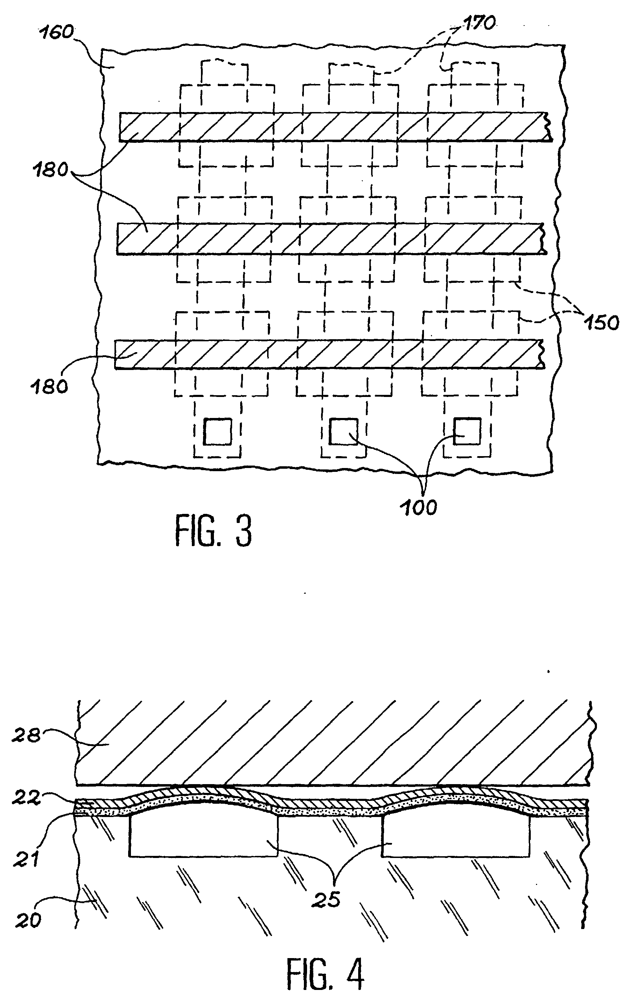

Selon le même principe, on peut obtenir une matrice de capteurs de pression. C'est ce que montre la figure 3 qui est une vue de dessus d'une telle structure. Sur cette figure, les cavités pressurisées sont représentées sous la référence 150, la couche d'oxyde supérieure sous la référence 160, des caissons conducteurs sous la référence 170, des électrodes supérieures sous la référence 180. La référence 100 représente des plots de connexion électrique avec les caissons conducteurs 170, ces plots étant déposés après gravure des couches supérieures aux caissons.

On a ainsi réalisé une matrice de capteurs de pression du type capacitif. Chaque capteur de pression est constitué par le condensateur élémentaire situé à l'emplacement du croisement d'une électrode 180 et d'une électrode 170 (ou caisson conducteur), entre lesquelles se trouve une cavité pressurisée 150.

La matrice de capteurs de pression obtenue comprend donc des lignes (par exemple les électrodes métalliques 180) et des colonnes (par exemple les caissons conducteurs 170). La pression dans un élément (i, j) de la matrice de capteurs, correspondant au croisement d'une ligne i et d'une colonne j, est obtenue par mesure de la capacité de l'élément (i, j). Pour cela, toutes les lignes, sauf la ligne i, et toutes les colonnes, sauf la colonne j, sont mises en haute impédance. On mesure alors la capacité existant entre la ligne i et la colonne j.

D'une façon similaire, on peut réaliser une structure présentant un contact électrique souple à un élément extérieur. C'est ce que montre la figure 4 où une pluralité de cavités 25 sont formées dans un substrat de silicium monocristallin 20 et fermées par une membrane d'oxyde 21. En utilisant une technique de masquage, seules les cavités 25 ont reçu un apport d'ions selon une dose telle que ces cavités sont pressurisées, ce qui provoque le bombement de la membrane 21 fermant ces cavités pour constituer des bossages ou des coussinets. La membrane 21 est recouverte d'une couche métallique 22. On obtient ainsi une structure qui permet d'assurer un contact électrique souple avec un élément extérieur 28.

Bien que les exemples décrits ci-dessus concernent une structure dont les principaux éléments constitutifs sont en silicium et en oxyde de silicium, le procédé selon la présente invention peut s'appliquer à tout matériau solide pourvu que l'épaisseur des éléments permettent d'implanter de manière appropriée des ions dans une cavité qui est constituée dans cette structure.

## Revendications

1. Procédé d'introduction d'une phase gazeuse dans au moins une cavité fermée (15, 150, 25) et présente au sein d'une structure, **caractérisé en ce qu'**il consiste à effectuer une implantation ionique pour introduire des ions aptes à générer la phase gazeuse désirée dans la cavité (15, 150, 25), ladite implantation étant effectuée avec une énergie suffisante pour que les ions puissent atteindre la cavité et selon une dose suffisante pour obtenir une pression déterminée dans la cavité.

2. Procédé selon la revendication 1, **caractérisé en ce que** la phase gazeuse résulte de l'implantation d'ions d'éléments différents.

3. Procédé selon l'une des revendications 1 ou 2, **caractérisé en ce que** lesdits ions sont des ions d'hydrogène ou de gaz rares.

4. Procédé selon l'une quelconque des revendications 1 à 3, **caractérisé en ce que** l'énergie d'implantation est telle qu'elle permet d'obtenir une concentration maximum théorique des ions à l'intérieur de la cavité (15, 150, 25).

5. Procédé selon l'une quelconque des revendications 1 à 4, **caractérisé en ce que** l'implantation ionique est effectuée selon une dose permettant de conférer à la phase gazeuse constituée dans ladite cavité (25) une pression suffisante pour déformer une paroi (21) de la cavité.

6. Procédé selon la revendication 5, **caractérisé en ce que** ladite paroi (21) est déformée sous la forme d'un bossage ou d'un coussinet.

7. Procédé selon l'une des revendications 5 ou 6, **caractérisé en ce que** la face externe de ladite paroi (21) est rendue conductrice, la structure pouvant ainsi présenter un contact électrique souple (22) à un élément extérieur (28).

8. Procédé selon l'une quelconque des revendications 1 à 6, **caractérisé en ce qu'**il prévoit la formation d'électrodes (17, 18 ; 170, 180) positionnées de façon à former au moins un condensateur où ladite phase gazeuse intervient comme diélectrique.

9. Utilisation du procédé selon la revendication 8 pour obtenir un capteur de pression par mesure de la capacité dudit condensateur.

10. Utilisation du procédé selon la revendication 8 pour obtenir une matrice de capteurs de pression par mesure des capacités correspondant aux condensateurs formés à partir d'une matrice de cavités implantées (150).

## Claims

1. Method for inserting a gaseous phase in at least one sealed cavity (15, 150, 25) existing within a structure, **characterized in that** it consists of conducting ion implantation to insert ions able to generate the required gaseous phase inside the cavity (15, 150, 25) said implantation being carried out with sufficient energy for the ions to be able to reach the cavity and in a sufficient dose to obtain a determined pressure within the cavity.

2. Method in accordance with claim 1, **characterized in that** the gaseous phase arises through the implantation of ions of different elements.

3. Method in accordance with claim 1 or 2, **characterized in that** said ions are ions of hydrogen or of rare gases.

4. Method in accordance with any one of the claims 1 to 3, **characterized in that** implantation energy is such that it can lead to obtaining a theoretic maximum concentration of ions inside the cavity (15, 150, 25).

5. Method in accordance with any one of the claims 1 to 4, **characterized in that** ion implantation is carried out in a dose which allows the gaseous phase formed within said cavity (25) to be given sufficient pressure to deform one wall (21) of the cavity.

6. Method in accordance with claim 5, **characterized in that** said wall (21) is deformed into a boss or pad shape.

7. Process in accordance with claim 5 or 6, **characterized in that** the outside surface of said wall is made conductive, so that the structure can have soft electric contact (22) with an outside element (28).

8. Method in accordance with any one of the claims 1 to 6, **characterized in that** provision is made for the formation of electrodes (17, 18; 170, 180) positioned in such manner as to form at least one capacitor in which said gaseous phase acts as a dielectric.

9. Use of the method in accordance with claim 8 to obtain a pressure sensor by measurement of the capacity of said capacitor.

10. Use of the method in accordance with claim 8 to obtain a matrix of pressure sensors by measurement of the capacitances relating to the capacitors formed from a matrix of implanted cavities (150).

## Patentansprüche

1. Verfahren zum Einbringen einer Gasphase in wenigstens einen geschlossenen und im Innern einer Struktur vorhandenen Hohlraum (15, 150, 25),
**dadurch gekennzeichnet,**
**dass** es darin besteht, eine Ionenimplantation durchzuführen, um Ionen, fähig die gewünschte Gasphase zu erzeugen, in den Hohlraum (15, 150, 25) einzubringen, wobei die genannte Implantation mit einer so großen Energie ausgeführt wird, dass die Ionen den Hohlraum erreichen und dies mit einer ausreichenden Dosis, um in dem Hohlraum einen bestimmten Druck zu erzeugen.

2. Verfahren nach Anspruch 1, **dadurch gekennzeichnet, dass** die Gasphase aus der Implantation von Ionen verschiedener Elemente resultiert.

3. Verfahren nach einem der Ansprüche 1 oder 2, **dadurch gekennzeichnet, dass** die Iohen Wasserstoff- oder Edelgas-Ionen sind.

4. Verfahren nach einem der Ansprüche 1 bis 3, **dadurch gekennzeichnet, dass** die Implantationsenergie derartig ist, dass es möglich ist, eine theoretische Maximalkonzentration der Iohen im Innern des Hohlraums (15, 150, 25) zu erreichen.

5. Verfahren nach einem der Ansprüche 1 bis 4, **dadurch gekennzeichnet, dass** die Implantationsenergie gemäß einer Dosis ausgeführt wird, die ermöglicht, der in dem genannten Hohlraum (25) gebildeten Gasphase einen ausreichend Druck zu verleihen, um eine Wand (21) des Hohlraums zu verformen.

6. Verfahren nach Anspruch 5, **dadurch gekennzeichnet, dass** die genannte Wand (21) buckel- oder kissenförmig verformt wird.

7. Verfahren nach einem der Ansprüche 5 oder 6, **dadurch gekennzeichnet, dass** die Außenseite der genannten Wand (21) leitfähig gemacht wird, wobei die Struktur dann mittels einer biegsamen Schicht (22) elektrischen Kontakt mit einem äußeren Element (28) haben kann.

8. Verfahren nach einem der Ansprüche 1 bis 6, **dadurch gekennzeichnet, dass** es die Bildung von Elektroden (17, 18; 170, 180) vorsieht, so positioniert, dass sie wenigstens einen Kondensator bilden, wo die genannte Gasphase als Dielektrikum wirkt.

9. Benutzung des erfindungsgemäßen Verfahren nach Anspruch 8, um durch Messen der Kapazität des genannten Kondensators einen Drucksensor zu erhalten.

10. Benutzung des erfindungsgemäßen Verfahren nach Anspruch 8, um durch Messen der Kapazitäten, die den aus einer Matrix implantierter Hohlräume (150) gebildeten Kondensatoren entsprechen, eine Drucksensoren-Matrix zu erhalten.
